# EUROPEAN PATENT SPECIFICATION

(11) **EP 0 439 619 B1**
(45) Date of publication and mention of the grant of the patent: **23.04.1997**
(21) Application number: 90911693.1
(22) Date of filing: 02.08.1990
(51) Int. Cl.: H01L 21/68

(54) **CONTACT MEMBER RELATIVE TO ELECTRICALLY CHARGED MATERIAL**
KONTAKTGLIED HINSICHTLICH ELEKTRISCH GELADENEN MATERIALS
ELEMENT DE CONTACT DESTINE A TOUCHER UN MATERIAU CHARGE ELECTRIQUEMENT

(30) Priority: 18.08.1989 JP 212146/89
(43) Date of publication of application: 07.08.1991
(73) Proprietor: OHMI, Tadahiro, Sendai-shi Miyagi-ken 980 (JP); TAKASAGO NETSUGAKU KOGYO KABUSHIKI KAISHA, Chiyoda-ku, Tokyo 101 (JP)
(72) Inventor: OHMI, Tadahiro, Sendai-shi Miyagi-ken 980 (JP); INABA, Hitoshi, Tokyo 194 (JP)
(74) Representative: Weitzel, Wolfgang, Dr.-Ing.
(86) International application number: JP9000985
(87) International publication number: WO9103076

(56) References cited:
- DE-A- 3 810 594
- JP-U- 0 167 755
- JP-U- 0 649 086
- RESEARCH DISCLOSURE. no. 307, November 1989, HAVANT GB page 818; 'Wafer Handeling Robotic End-Of-Arm Tool for Operation in Clean Room Environments' Abstr.nr. 30 759

## Description

### TECHNOLOGICAL FIELD OF THE INVENTION

This invention relates to an electrified object contact component, i.e. a component bearing an electrostic charge.

### [BACKGROUND OF THE INVENTION]

In an LSI manufacturing process, electrification of a wafer is a big problem, and it is urgently required to establish a technology for prevention of electrification.

Description is hereunder made for troubles caused by electrification of a wafer, as an example of an electrified object.

### (Electric potential in an electrified object)

As a wafer is generally handled with insulating fluororesin or quarts for preventing it from being contaminated, a very high electric potential is charged when it contacts contacts while being handled. Results of measurement of electric potential in electrified wafers are shown in Table 1 below.

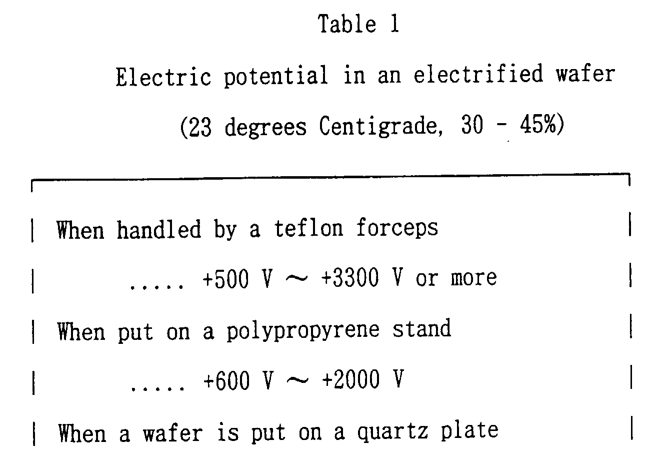

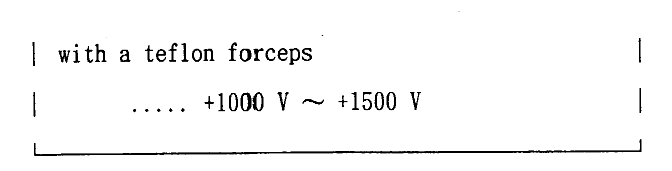

A range of measurement by an electrometer = -3300 V ∼ +3300 V

As shown by this result, it has turned out that, when a silicon wafer is handled by a resin material or quartz, always positive electricity is charged in the wafer because of the electrification column, and also that the electric potential is fairly high.

### (Troubles caused by electrification of a wafer)

Also it has turned out that, when a wafer is electrified, the following 2 types of trouble occur and cause substantial decrease in yield in a semiconductor manufacturing process;
① Adhesion of airborne particles due to static electricity force
② Destruction of a device due to discharge of static electricity

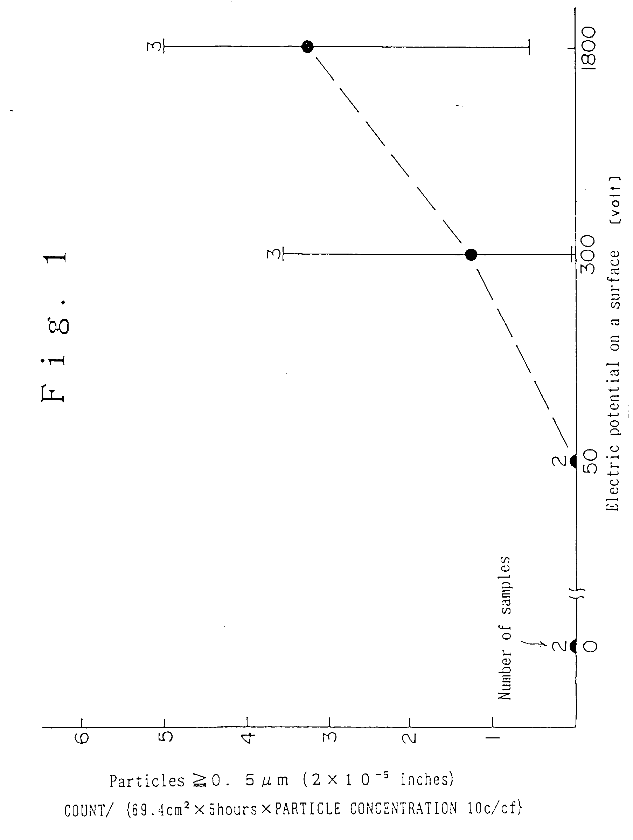

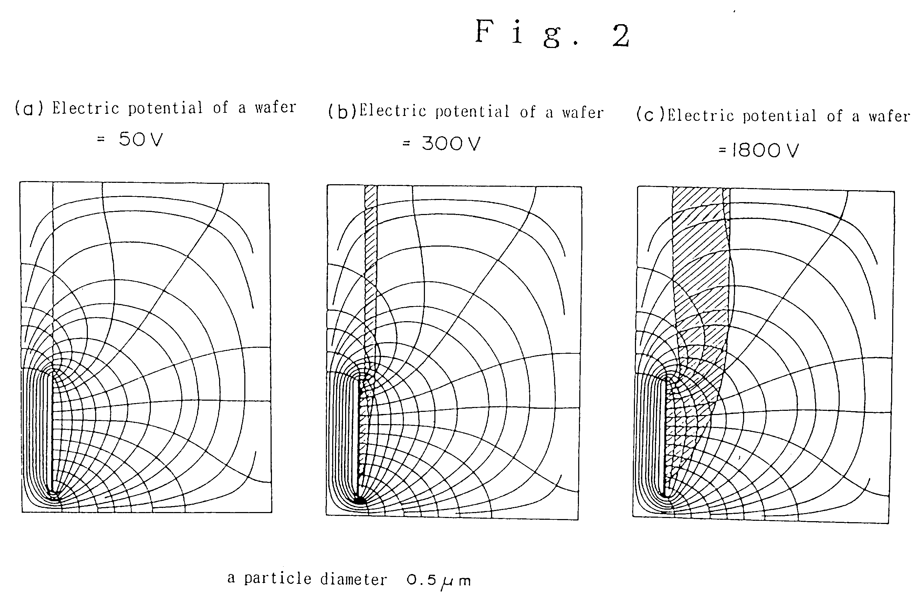

Results of a testing to investigate the trouble ① and computing results for the trouble are introduced below. Fig. 1 shows a number of particles with a diameter of 0.5 µm or more which adhered to a surface of an electrified wafer when a 5-inch wafer was left on a conductive grating floor for 5 to 10 hours in a clean room in a vertical position with a 2 cm high insulating stand. The horizontal axis shows electric potentials in the wafer and the vertical axis shows a number of deposited particles (converted to a number of particles which adhered to a central area of a wafer when the wafer is left for 5 hours in the atmosphere with a density of 10 particles having a diameter of 0.5 µm or more/cf). As adhesion of particles due to gravity does not occur on a vertical surface, adhesion of particles is not observed when electric potential of a wafer is in a low range from 0 V to 50 V. In accordance with increase of electric potential of the wafer to 300 V or to 1800 V, the number of adhered particles sharply increases, which shows that the adhesion is caused by a static electricity force. Fig. 1 shows results of measurement of effects by static electricity force to relatively large particles , and generally as diameter of a particle becomes smaller, effects of this static electricity force become more visible acceleratingly. When electric potential of a wafer is at least below 50 V, any particle does not adhere to the wafer. Herein, a state where electric potential of a wafer is 50 V or below is defined as a state where electric potential of the wafer has been neutralized. Fig. 2 shows a range of movement of particles moved and adhered due to static electricity force on an effective section of a wafer calculated on the assumption that electric potential of the wafer is 1000 V and electric potential at the peripheral rectangular frame line is zero. As a force to make particles adhere to a wafer, only gravity (including buoyancy) and static electricity force are taken into account. Also it is assumed that the particle density is 1 g/cm³. This drawing shows that particles in an area enclosed by oblique lines adhere to the effective section of the wafer. Results of the calculation show that an area where particles with the diameter of 2µm or more adhere to is very narrow and virtually no particle adheres to the wafer. As a particle diameter becomes smaller to 0.5µm or to 0.1µm, the adhesion area sharply becomes larger, which indicates that, when diameter of a particle is small, effect of static electricity force over the particle in terms of adhesion to a surface of an object is very large.

Results of the experiment and calculation described above indicate that preventing a wafer from being electrified is very important for preventing a surface of the wafer from being contaminated by particles.

### Background Technology

Conventional art for preventing a wafer from being electrified is classified to the following two ways.
① Generating ions by means of corona discharge method and neutralizing an electrified wafer with the ions.
② Neutralizing electric charge in a wafer by handling the wafer with a grounded conductive resin material
③ Neutralizing electric charge in a wafer by handling the wafer with a grounded metallic material.

However, all of these technics have defects which may be fatal in the age of submicron ULSI, and unless these defects are removed, they are not applicable for neutralization of enhanced wafers.

It has turned out that the corona discharge in ① above has the following problems.
(1) Generation of corpuscles from a tip of a discharging electrode.
(2) Generation of ozone

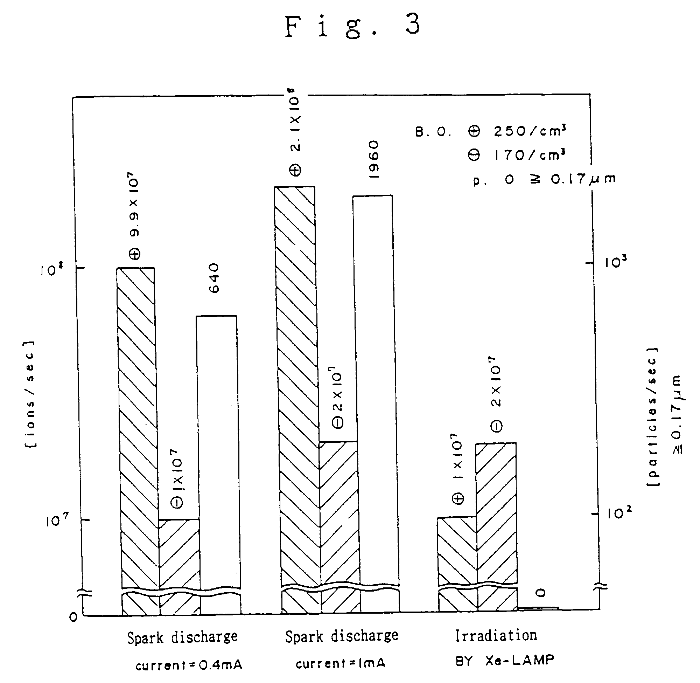

This inventor investigated a cause for (1), and found out that spattering due to ions occurs at a tip of a discharging electrode and corpuscles are generated because of this phenomenon. Fig.3 shows numbers of ions and corpuscles (≧0.17µm) generated when spark discharge is performed by using a tungsten needle. The numbers of generated ions and corpuscles vary according to strength of loaded discharge current, and when a current value is 1 mA, plus ions are generated at a rate of 200 millions pcs/sec with particles with a diameter of 0.17µm or more generated at a rate of 1960 pcs/sec. It is conceivable that particles with smaller diameter are generated at a higher rate. As this experiment result shows a case of spark discharge, it is conceivable that a quantity of dust generated in corona discharge would be smaller. But, as spattering, which is the same phenomenon as that in case of spark discharge, occurs, the possibility of dust generation can not be denied.

Then, ozone in (2) is generated when air is electrolytically dissociated, and as ozone's oxidizing effect is very strong, an oxidized film is rapidly formed on a surface of a wafer, which causes various troubles. Also, it has turned out that high polymer materials often used as, for instance, coating material for power cables are dissolved by ozone, which causes many troubles such as insulation fault. Unless these problems are solved, an electrified surface neutralizing method making use of ions generated by means of corona discharge can not be applied to wafers.

In the method ②, a conductive substance mixed with a resin material is a source of contaminants for wafers. Generally carbon or metal is used as a substance to be mixed with. When the substance contacts a wafer, the impurities adhere to the wafer, which causes a dark current or a leak current.

Also in the method ③, like in the method ②, conductive metal contacts a wafer, which may generate a dark current or a leak current (contamination by metal) causing severe contamination, so that the method is not applicable for production of wafers unless it is improved.

### DISCLOSURE OF THE INVENTION

An electrified object contact component according to the present invention is characterized in that an oxide film with a thickness from several nm to 10 nm (several tens to 100 Å), formed in high purity oxidizing atmosphere has been formed at least in a section which contacts an electrified object.

The electrified object herein includes, for instance, a wafer.

Also, the contact component herein includes, for instance, a wafer manipulator, a wafer mount in a reaction chamber, and a wafer carrier in a wafer transfer tunnel.

### Function

Description is made hereunder for working as well as detailed composition of the present invention.

At first, description is made for formation of an insulating layer.

An oxide film with a thickness from several nm to 10 nm (several tens to 100 Å) is formed by oxidizing metal, a surface thereof having been processed by electropolishing or other appropriate technics to a mirror surface ( preferably with an Rmax of 1 µm or less) without any affected zone due to the processing, in high purity oxidizing atmosphere having a very low moisture density ( of preferably 10 ppb or less, or more preferably several ppb or less). This oxidizing process is called field assist oxidization, wherein an oxygen molecular adhered to a metal surface is ionized to a negative ion (O₂-) and the negative ion is pulled through the oxide film into an interface between the oxide film and the metal, reacting to the metal and forming an oxide film. In this oxidization process, if there are few impurities (especially H₂O), the oxide film formed there has a very minute construction having a surface with low degassing properties and high abrasion resistance as well as high chemical resistance. A thickness of an oxide film largely depends on the metallic material and temperature applied for the oxidization processing, and for instance, in case of stainless steel (316L), a film thickness formed under a temperature of 350 degrees Centigrade is in a range from 5 to 6 nm (50 to 60 Å), and that formed under a temperature of 380 degrees Centigrade is in a range from 7 to 8 nm, (70 to 80Å). A time required for the oxidization processing is in a range from 1 - 9 hours. By using a metallic material having a surface oxidized as described above for handling a wafer, an electric charge in an electrified wafer can be neutralized because of the tunnel effect in an oxide film. The electric charge neutralizing mechanism making use of the tunnel effect can be explained as follows. When a positively electrified silicon wafer contacts a surface of a metallic material covered with said oxide insulating film, as many electrons are used for neutralization, electrons are supplied from the side of a metallic material earthed to the ground in a quantity equivalent to that of electrons used for neutralization so that an existence probability of electrons beyond an insulating film is maintained at a constant level. To the contrary, if a wafer is electrified negatively, an existence probability of electrons is maintained at a constant level by making surplus electrons in the wafer flow to the side of a metallic material. Thus, finally electrons remain in the wafer contacting a metallic material having a surface oxidized through the processing as described above according to a probability defined by a thickness of an oxide film and an electric potential of the wafer becomes extremely low.

On the other hand, as an metallic oxide film processed by means of the field assist oxidization in oxygen atmosphere containing few impurities (especially H₂O) has insulating properties and also its abrasion resistance is high, even if it contacts a wafer, contamination by a metallic material due to contact abrasion does not occur, which is different from conventional cases. Namely, this characteristics means that a metallic material with said metallic oxide film with its low probability to cause contamination of a wafer is equivalent to conventional wafer handling materials made of quartz or fluororesin.

### BRIEF DESCRIPTION OF THE DRAWING

Fig. 1 is a graph which shows results of an experiment concerning adhesion of particles to an electrified wafer.

Fig.2 is a distribution diagram which shows results of a calculation concerning adhesion of particles to an electrified wafer.

Fig.3 is a graph which shows numbers of ions and corpus generated by means of an ion generating method making use of electric discharge and by means of an ion generating method making use of an photoelectric effect.

Fig.3 is stereoscopic drawings showing applications of said contact component according to the present invention.

Herein, 1 is an electrified object (wafer), 2 is a metallic material having an oxidized surface, 3 is a manipulator, 4 is is a ground , 5 is a metallic material having an oxidized surface (wafer mount), 6 is a wafer, 7 is a wafer reaction chamber, 8 is a ground , 9 is a wafer transfer tunnel, 10 is a metallic material having an oxidized surface (wafer carrier), 11 is a wafer, and 12 is a ground.

### OPTIMAL FORM FOR EMBODIMENT OF THE INVENTION

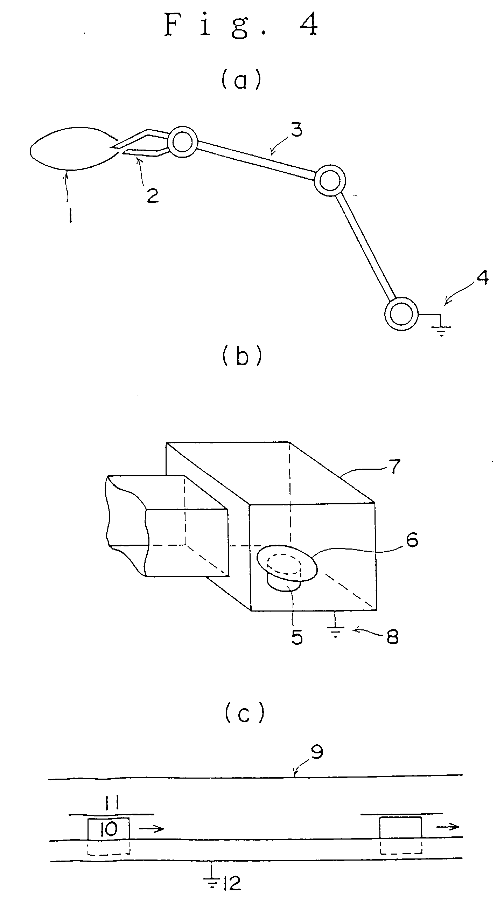

The contact component according to an embodiment of the present invention is shown in Fig. 4. Herein, (a) is a manipulator for wafer handling, wherein at least a metallic material having an oxidized surface is used for a section directly contacting a wafer and electrification of a wafer is prevented by means of grounding. (b) shows a case wherein the metallic material having an oxidized surface is used for the wafer mount 5 in a wafer reaction chamber. Namely, the wafer mount is made of metal with an oxide film formed on a section directly contacting a wafer. Also in this case, as the chamber is made of metal, grounding is provided at a point as shown in this figure. (c) shows a case wherein the wafer transfer tunnel is all metallic and a metallic material having an oxidized surface is used in a section of the wafer transfer tunnel 10 directly contacting a wafer. Balance of electrons is controlled, as shown in this drawing, by grounding the wafer transfer tunnel for preventing a wafer from being electrified.

In the 3 embodiments of the present invention described above, a thickness of an oxide film layer of a metallic material having an oxidized surface is in a range from several nm to 10 nm (several tens to 100 Å), and electric potential of each wafer can be suppressed to 50 V or below in any processing, and even if particles exist around a wafer, adhesion of the particles to the wafer surface does not occur.

### INDUSTRIAL APPLICABILITY

By using the contact component according to the present invention, electric potential of a wafer can always be suppressed to 50 V or below, and additionally contamination of a wafer (especially by a metallic material) can completely be eliminated.

## Claims

1. Method for manufacturing of a metallic object contact component bearing an electrostatic charge, characterized in that an oxide film is formed in a high purity oxidizing atmosphere, having a thickness from several nm to 10 nm at least in a section which will directly contact an electrified object.

## Patentansprüche

1. Verfahren zum Herstellen eines metallischen Kontaktelementes, das eine elektrostatische Ladung trägt, dadurch gekennzeichnet, daß in einer hochreinen oxidierenden Atmosphäre ein Oxidfilm gebildet wird, mit einer Stärke von mehreren nm bis 10 nm wenigstens in einem Abschnitt, der einen elektrifizierten Gegenstand unmittelbar berührt.

## Revendications

1. Procédé pour la fabrication d'un élément métallique de contact, portant une charge éléctrique, charactérisé en ce qu'un film d'oxyde est formé dans une atmosphère oxydante la plus pure, comprenant un épaississeur de plusieurs nm à 10 nm au moins à une section contactant directement un objet éléctrifié.
